# EUROPEAN PATENT APPLICATION

(11) **EP 4 719 024 A2**
(43) Date of publication of application: **01.04.2026**
(21) Application number: 26152911.9
(22) Date of filing: 29.04.2022
(51) Int. Cl.: H10P 14/47, H10W 20/00, H10W 20/20, H10W 20/44

(54) **SUPERCONDUCTING THROUGH SUBSTRATE VIAS**

(30) Priority: 04.05.2021 FI 20215520
(62) Divisional of application: 22170866.2
(71) Applicant: IQM Finland Oy, 02150 Espoo (FI)
(72) Inventor: Jenei, Máté, 02150 Espoo (FI); Chan, Kok Wai, 02150 Espoo (FI); Ahmad, Hasnain, 02150 Espoo (FI); Venkatesh, Manjunath Ramachandrappa, 02150 Espoo (FI); Liu, Wei, 02150 Espoo (FI); Yang, Lily, 02150 Espoo (FI); Li, Tianyi, 02150 Espoo (FI); Orgiazzi, Jean-Luc, 02150 Espoo (FI); Ockeloen-Korppi, Caspar, 02150 Espoo (FI); Landra, Alessandro, 02150 Espoo (FI); Palma, Mario, 02150 Espoo (FI)
(74) Representative: Berggren Oy

(57) **Abstract**

The invention relates to a product comprising a substrate, the substrate comprising one or more superconducting through-substrate vias which extend through the substrate from a first side of the substrate to a second side of the substrate, wherein the interior walls of the through-substrate vias are coated in a seed layer and wherein the through-substrate vias are filled with a superconducting filler material. The superconducting filler material is rhenium and the substrate is a silicon substrate.

## Description

### Technical Field

The invention relates to the fabrication of high component density integrated circuit devices.

### Background

In 3D integrated circuit devices, the integrated circuit components occupy not just a single substrate side, but are distributed on both sides of a substrate and/or on the sides of multiple unified dice, e.g. in a stack. The distribution of circuit components on different layers or design faces provides more flexibility on qubit chip design and also higher component density.

The superconducting through silicon/substrate via (STSV) technology is a core aspect of high-qubit density quantum processing units, in which the two sides of a substrate are electrically connected by a (partially) metallized opening. Mitigating losses in STSVs is necessary to create a versatile 3D-integrated qubit design, in which the STSV can be the part of a qubit, readout structure, or control lines. Furthermore, in existing hollow STSV structures, securing a wafer during resist spinning - an essential step in the formation of quantum processing unit components on the wafer - requires additional fabrication steps because the hollow STSV structures prevent the formation of a sufficiently strong vacuum to hold the wafer on the spinning chuck. These additional fabrication steps may also introduce impurities that can negatively affect the performance of the superconducting connection.

Publications US 2013/140688 A1, US 2008/299759 A1, WO 2019/117975 A1, and US 2018/005887 A1 each present a product comprising a different type of TSVs. However, none of these publications discloses a combination of materials whose properties are optimised to perform well at the low temperatures required for operating a superconducting quantum processing unit as well as during fabrication steps subsequent to forming TSVs.

### Summary

According a first aspect of the invention, a product is provided. The product comprises a substrate, the substrate comprising one or more superconducting through-substrate vias which extend through the substrate from a first side of the substrate to a second side of the substrate, wherein the interior walls of the through-substrate vias are coated in a seed layer and wherein the through-substrate vias are filled with a superconducting filler material. The superconducting filler material is rhenium and the substrate is a silicon substrate.

The seed layer may be titanium nitride, niobium titanium nitride, copper or gold.

The seed layer is a superconducting material, or the seed layer may be induced to form a superconductor by the proximity of the superconducting filler material, e.g. by the Holm-Meissner effect.

The seed layer may extend over the first side of the substrate such that the superconducting material within the through-substrate vias is not covered by the seed layer on the first side of the substrate.

The seed layer may extend through the through-substrate vias to the second side of the substrate such that the superconducting material within the through-substrate vias is covered by the seed layer on the second side of the substrate.

The areas of the seed layer that cover the superconducting material may be level with the surface of the second side of the substrate.

The product may further comprise a base metal layer on the first or second side of the substrate.

The base metal layer may be patterned to form components of a quantum processing unit.

The product may further comprise one or more components of a quantum processing unit on the first side of the substrate.

The product may further comprise one or more components of a quantum processing unit on the second side of the substrate.

At least one of the one or more components on the first side of the substrate may be electrically connected to at least one of the one or more components on the second side of the substrate by at least one of the one or more superconducting through-substrate vias.

### Brief Description of the Drawings

Figures 1A to 1I show the intermediate results of each step of the fabrication process for the product according to the present invention.
Figure 2 is a flow chart depicting the fabrication process for the product according to the present invention.

### Detailed Description

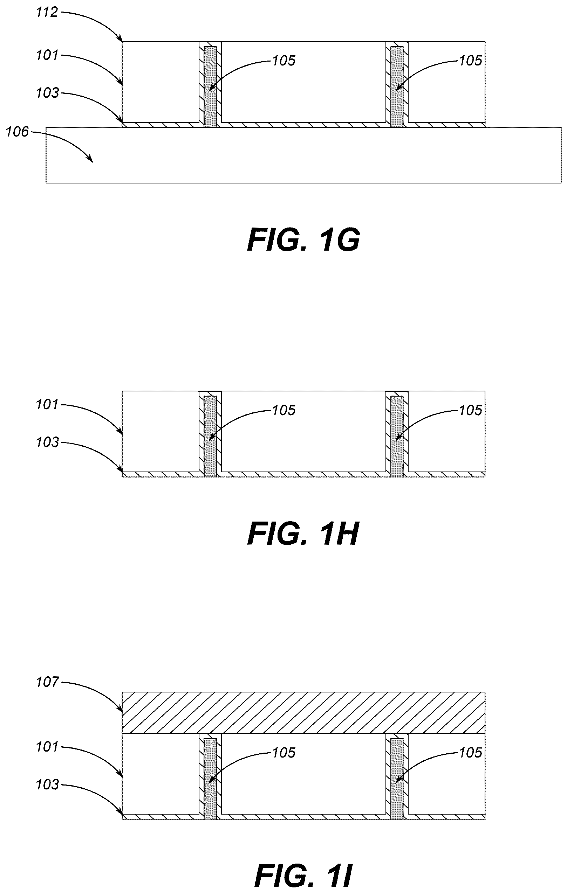

The present invention provides an integrated circuit product that includes TSVs produced according to the present invention. Such products are characterised by including a substrate which has one or more superconducting TSVs which extend through the substrate from a first side of the substrate to a second side of the substrate. The interior walls of the TSVs coated in a seed layer and the TSVs are filled with a superconducting filler material. An example of the TSVs that can be found in the product of the invention is shown in Figure 1H.

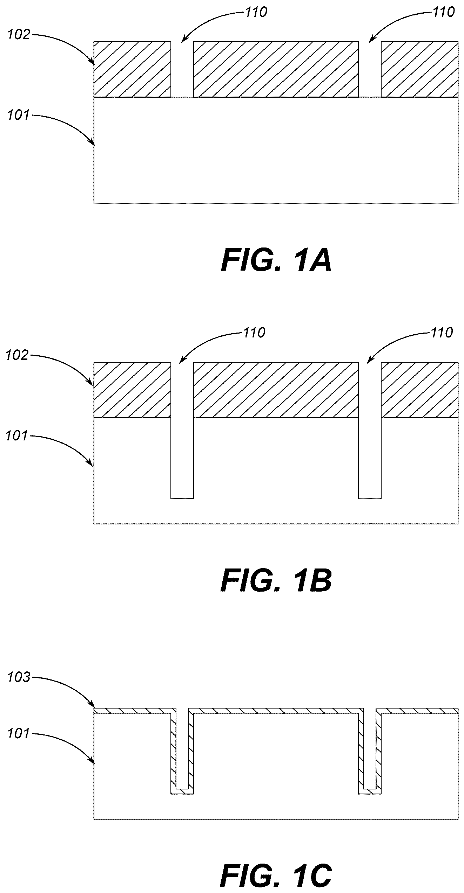

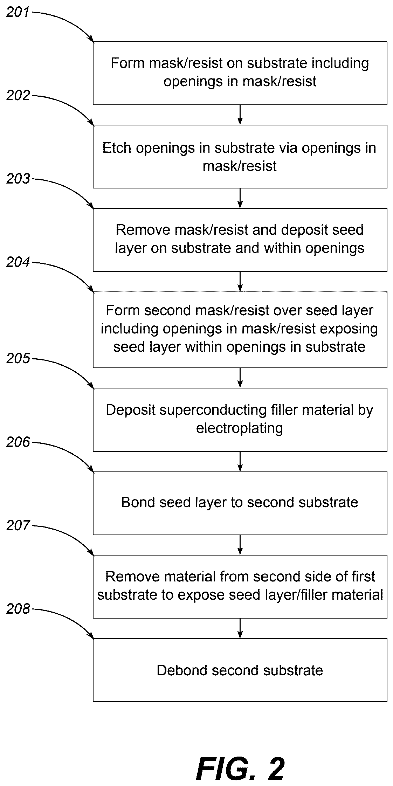

The product according to the present invention is described with reference to Figures 1A to 1I and Figure 2. The method for fabricating the product takes place before the formation of other elements on the substrate, such as quantum circuit components like a base metal layer and Josephson junctions. Figures 1A to 1I show the intermediate results of each step of the fabrication process of the present invention, while Figure 2 is a flow chart depicting the fabrication process.

Figure 1A shows a blank wafer or substrate 101 on which a first mask or resist 102 is formed on one side. The mask/resist 102 include one or more openings 110, which define the locations in which the TSVs will be formed in subsequent steps. Figure 1A shows the result of step 201 of the method shown in Figure 2, in which the mask/resist 102 is formed on a first side of the substrate. The substrate 101 is a silicon substrate, providing benefits that it is highly resistive, can be deep etched, and tolerates a low pH electroplating plating bath, which is employed in later steps. Mask/resist 102 may be a hardmask or photoresist, for example, and openings 110 may be formed by lithography or any other suitable process which enables openings 110 to be formed in a controlled manner at specific locations above the substrate 101.

Figure 1B shows the substrate 101 and mask/resist 102 following deep etching of the substrate via the openings 110 at step 202 of the process shown in Figure 2. The openings etched into the substate 101 extend partially through the substrate in a direction generally perpendicular to the surfaces of the substrate 101, which are typically parallel. However, it will be appreciated and be clear that the precise direction in which the openings extend through the substrate 101 is not important as long as they extend from the first side of the substrate 101 towards the second side 102, nor is it essential the first and second sides of the substate 101 be parallel. The depth of the openings in the substrate 101 defines the maximum depth of the resulting TSVs, therefore the opening should be etched to a depth at least equal to the minimum width of the final substrate width.

Figure 1C shows the substate 101 and a seed layer 103 that is deposited onto the substrate 101, including within the openings etched into the substrate 101, i.e. covering the interior wall or walls of the opening and the surface at the bottom of the opening, after the mask/resist 102 is removed. Figure 1C therefore shows the result of step 203 of the process shown in Figure 2. The seed layer 103 can be a single layer or a stack of multiple layers and is deposited by sputtering, e-beam evaporation, or atomic-layer deposition (ALD). The seed layer 103 is electrically conductive and forms a superconductor with the superconducting filler material. The seed layer 103 also acts as an adhesion layer, allowing a stronger bond between the substrate 101 and superconducting filler material. In an embodiment, the seed layer 103 is formed of plasma enhanced - ALD deposited titanium nitride, but other materials fulfilling the criteria set out above may be used instead, such as niobium titanium nitride. Alternatively, where physical vapour deposition is used, other materials, such as copper or gold, may be used for the seed layer on the same condition that the metal stack, i.e. the seed layer and filler material, is superconducting, for example as a result of the Holm-Meissner effect.

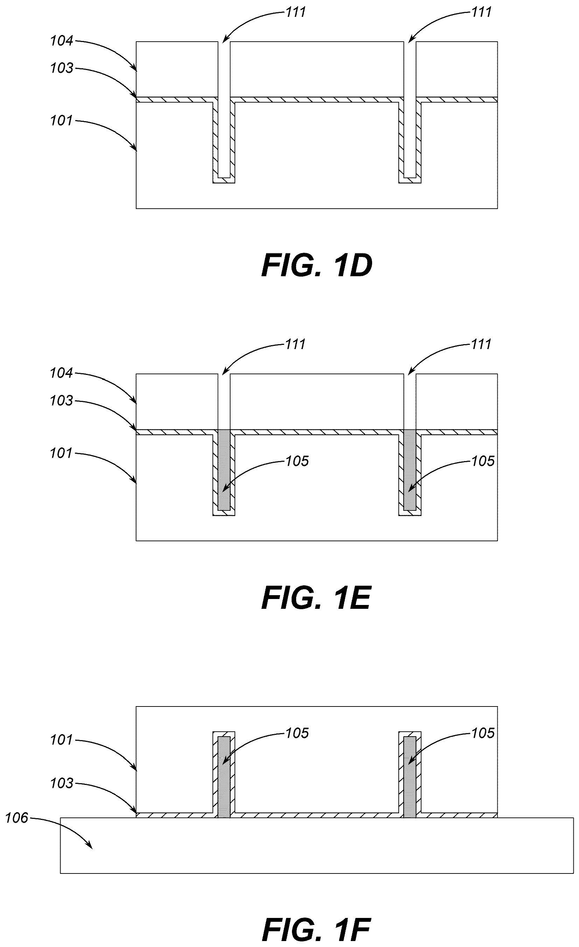

Figure 1D shows the result of the following step 204 shown in Figure 2, in which a second mask/resist 104 is deposited on the seed layer 103 above the substrate 101, i.e. such that the seed layer 103 is positioned between the mask/resist 104 and the substrate 101. Openings 111 are formed in the mask/resist 104 above the existing openings in the substrate 101 and seed layer 103 that were defined by the deep etching of the substrate 101 and subsequently coated with the seed layer 103. The second mask/resist 104 may be a hardmask or photoresist, for example, and openings 111 may be formed by lithography or any other suitable process which enables openings 111 to be formed in a controlled manner at specific locations above the substrate 101. The openings 111 in the mask/resist 104 covering the areas of the seed layer 103 that lie above the surface of the substrate 101, i.e. the edges of the mask/resist 104 may align with the edges of the seed layer, such that only the areas of the seed layer 103 that lie within the openings in the substrate 101 exposed.

Figure 1E shows the result after the superconducting filler material 105 is deposited within the openings in the substrate by electroplating at step 205 of method shown in Figure 2. The electroplating process is performed using the seed layer 103 as a cathode of an electrolytic cell, which also includes an anode, which may be made of an inert conductive material ("electrodeless electroplating") or may be made from the superconducting filler material itself, and an electrolyte bath, which contains ions of the superconducting filler material that is to be deposited. The electroplating process can be driven by either direct current or by an alternating current, i.e. using pulse electroplating. For some geometries, e.g. with particularly narrow or deep openings in the substrate, pulse electroplating may be necessary in order to consistently fill the opening. Since the seed layer 103 is covered by the second mask/resist 104 in all areas except those within the openings in the substrate 101, the superconducting filler material 105 is deposited only within the openings.

In existing superconducting TSV processes, the TSVs are typically hollow at the end of the fabrication process as the extremely temperatures under which superconducting devices must operate cause contraction of the materials that the device is formed of at different rates. Thus, elements such as filler material within the TSVs are subject to stresses and additional pressure that may adversely affect performance of the device.

The superconducting filler material 105 is rhenium. Rhenium has the advantageous property that its critical temperature increases under thermal contraction of the device. Furthermore, rhenium has a high melting point (3459K), thus Rhenium does not melt and reflow under the conditions required for the fabrication of components on the substrate 101 after the TSVs have been formed. Where rhenium is used, it may be electroplated in a solution of 18.2MΩ cm water, 25mM ammonium perrhenate (VII) (99%), and 0.1M sulfuric acid (96%-98%). Water-in-salt electrolytes may also contain 5M lithium chloride (98%) and tetrabutylammonium hydrogen sulphate (98%). It will of course be appreciated that the specific rhenium bath chemistry may vary from this example.

The superconducting filler material 105 fills the opening in the substrate 101 such that the filler material 105 completely blocks the opening in the substrate 101. Therefore, other materials still retain at least the advantage that the TSVs are filled and resist spinning when forming further components after formation of the TSVs can be performed without additional fabrication steps and without contaminating the TSVs with additional materials that might cause interference or dielectric loss.

Figure 1F shows the result of step 206 of the method of Figure 2, in which the mask/resist 104 is removed and the seed layer 103 is bonded to a second substrate 106 to enable the removal of material from the second, exposed side of the substrate 101 using wafer thinning techniques e.g. by chemical mechanical polishing (CMP), as shown in Figure 1G and in step 207 of the method of Figure 2. Material is removed from the second side of the substrate 101 until the seed layer 103 that was deposited at the bottom of the openings in the substrate 101 is exposed. This is sufficient to provide a superconducting connection from one side of the substrate 101 to the other, but material may continue to be removed until the superconducting filler material 105 is exposed. After the seed layer 103 or superconducting filler material 105 is exposed, the second substrate 106 is debonded at step 208 of the method shown in Figure 2 to leave the first substrate 101 with now fully formed TSVs, as shown in Figure 1H. It will be appreciated that other techniques than CMP can be used to expose the seed layer 103 or superconducting filler material 105 on the second side of the substrate 101, in which case the process steps shown in Figures 1F and 1G and steps 206, 207 and 208 may differ. Alternative techniques for exposing the seed layer 103 or superconducting filler material 105 include physical grinding, dry blanket etching or spin etching, for example.

In the completed TSV, the interior walls of each TSV, i.e. the interior walls of the opening in the substrate, are coated by the seed layer 103 and the TSV is filled with the superconducting filler material 105, i.e. the volume enclosed by the seed layer 103 coating the interior walls of the TSV are filled with the superconducting filler material 105.

Figure 1I shows a further step in which a base metal layer 107 is deposited onto the substrate 101 with now formed TSVs. This is a possible first step in the fabrication of components on both sides of the substrate 101, which will ultimately be connected to one another through the TSVs. As such, Figure 1I does not represent a step of the method of forming the TSVs per se.

## Claims

1. A product comprising a substrate (101), the substrate (101) comprising one or more superconducting through-substrate vias which extend through the substrate from a first side of the substrate (101) to a second side of the substrate (101), wherein the interior walls of the through-substrate vias are coated in a seed layer (103) and wherein the through-substrate vias are filled with a superconducting filler material (105), wherein the superconducting filler material (105) is rhenium and the substrate (101) is a silicon substrate.

2. The product of claim 1, wherein the seed layer (103) is titanium nitride, niobium titanium nitride, copper or gold.

3. The product of claim 1 or 2, wherein the seed layer (103) is a superconducting material

4. The product of any preceding claim, wherein the seed layer (103) extends over the first side of the substrate (101) such that the superconducting material (105) within the through-substrate vias is not covered by the seed layer (103) on the first side of the substrate (101).

5. The product of any preceding claim, wherein the seed layer (103) extends through the through-substrate vias to the second side of the substrate (101) such that the superconducting material (105) within the through-substrate vias is covered by the seed layer (103) on the second side of the substrate (101).

6. The product of claim 5, wherein the areas of the seed layer (103) that cover the superconducting material (105) are level with the surface of the second side of the substrate (101).

7. The product of any preceding claim, wherein the product further comprises a base metal layer (107) on the first or second side of the substrate (101).

8. The product of claim 7, wherein the base metal layer (107) is patterned to form components of a quantum processing unit.

9. The product of any preceding claim, wherein the product further comprises one or more components of a quantum processing unit on the first side of the substrate (101).

10. The product of any preceding claim, wherein the product further comprises one or more components of a quantum processing unit on the second side of the substrate (101).

11. The product of claims 9 and 10, wherein at least one of the one or more components on the first side of the substrate (101) is electrically connected to at least one of the one or more components on the second side of the substrate (101) by at least one of the one or more superconducting through-substrate vias.

12. The product of any preceding claim, wherein the superconducting filler material (105) is present only within the through-substrate vias.
